# EUROPEAN PATENT APPLICATION

(11) **EP 1 096 561 A2**
(43) Date of publication of application: **02.05.2001**
(21) Application number: 00308820.0
(22) Date of filing: 06.10.2000
(51) Int. Cl.: H01L 21/68

(54) **Method for rapid dechucking of a semiconductor wafer from an electrostatic chuck**

(30) Priority: 08.10.1999 US 415327
(71) Applicant: Applied Materials, Inc., Santa Clara, California 95054 (US)
(72) Inventor: Leeser, Karl F., Sunnyvale, CA 94087 (US)
(74) Representative: Bayliss, Geoffrey Cyril

(57) **Abstract**

A method for rapidly dechucking a wafer (114) from a chuck (106) by applying a voltage between the wafer and the electrode that uses a sequence of resonant discharge events such that residual charge is removed. The voltage is a sequence of decaying oscillating waveforms passively produced from a resonant circuit that provides a decaying electric field at the wafer to chuck surface interface. The form of this field at this interface is very important to achieving rapid dechucking of less than 200 Ms.

## Description

The invention relates to a method of rapidly dechucking a semiconductor wafer from an electrostatic chuck. More particularly, the invention relates to a method of dechucking a wafer from an electrostatic chuck by using a sequence of resonant discharge events.

Electrostatic chucks (ESC) are used for holding a workpiece in various applications ranging from holding a sheet of paper in a computer graphics plotter to holding a semiconductor wafer within a semiconductor fabrication process chamber. Although electrostatic chucks vary in design, they all are based on the principle of applying a voltage to one or more electrodes in the chuck so as to induce opposite polarity charges in the workpiece and electrode(s), respectively. The electrostatic attractive force between the opposite charges presses the workpiece against the chuck, thereby retaining the workpiece.

One problem that arises with the use of an ESC is the difficulty of removing the residual electrostatic force between the workpiece and the chuck during "dechucking". This residual force results from electric charges having accumulated at the interface between the workpiece and the ESC support surface. One technique for dechucking involves connecting both the electrode and the workpiece to ground. Another technique reverses the polarity of the DC chucking voltage applied to the electrodes to discharge the electrodes. However, these techniques are not completely effective at removing all the charge on the electrodes and the wafer. Consequently, a mechanical force is often needed to overcome the remaining attractive electrostatic force due to residual charges on the electrodes and wafer. At times, the mechanical force used to release the wafer may cause the wafer to "pop", i.e., to be released from the chuck in some unpredictable manner, which may cause either wafer damage or difficulty in retrieving the wafer from an unintended position. Therefore, a successful dechucking operation is one which leaves the wafer in a state subject to acceptably low residual electrostatic attractive force without "popping" the wafer.

Furthermore, when using these common dechucking practices that simply remove the potential difference between the electrodes, the time required to dechuck by these methods is defined by the RC time constant of the high voltage electrical circuit as well as the effective charge relaxation time constant of the electrode-wafer system. This time constant is given by the effective resistivity-permitivity product, τ_{cr}=ρ∈ₒ∈ᵣ, where p is the volume resistivity of the dielectric layer between the electrode and the wafer (i.e., the chuck material), ∈ₒ is the permittivity of free space, and ∈ᵣ is the relative permittivity of the dielectric layer. The total time required to dechuck by this method is often on the order of several seconds. Such a long dechucking period is generally not a concern in deposition or etch processes.

Other dechucking methods include applying to the ESC an optimal, but non-zero, dechucking voltage. A commonly-assigned U.S. patent 5,459,632 issued to Birang et al. on October 17, 1995, and is herein incorporated by reference, discloses a method of determining and applying an optimal dechucking voltage which has the same polarity as that of the chucking voltage. Another method involves determining and applying an optimal dechucking voltage for an optimal dechucking period. This is the subject of another commonly-assigned U.S. patent 5,818,682 issued to Loo on October 6, 1998, and is herein incorporated by reference. Although these prior art dechucking methods are effective at removing the residual charge from the wafer and electrodes, none of these prior art references are concerned with very rapid dechucking, i.e., on the order of a hundred milliseconds.

The need for a rapid dechucking operation is most keenly felt in single wafer/single chamber processing systems. In a system such as a single wafer ion implant system, the time required to dechuck a wafer can have a substantial impact on the throughput of the system. In US patent 5,444,597 issued to Blake et al. on August 22, 1995, a bipolar electrostatic chuck is described that retains a wafer in an ion implant system. The bipolar chuck has a pair of electrodes embedded in the dielectric chuck material and applies a differential voltage to the electrode pair to achieve charge accumulation on the backside of the wafer and, ultimately, an electrostatic force to retain the wafer. The wafer is dechucked by applying a DC voltage having a polarity opposite that of the chucking voltage, then applying a switched DC waveform (in effect, an AC waveform) to remove any residual charge. Because the dechucking voltage is directly connected to the electrode pair and not to the wafer, the wafer forms, in essence, a floating electrode. As such, charge is removed indirectly from the wafer. This removal of charge from the wafer is very difficult and can require a substantial amount of time as the interface discharges.

Additionally, the dechucking duration is exacerbated in systems where the platen supporting the wafer is vertically oriented during wafer processing, e.g., ion implant equipment. In these systems, gravity does not aid the chucking process and, to ensure sufficient wafer retention while moving the platen to a vertical orientation, a very strong chucking force is required. Such a strong chucking force requires a substantial chucking voltage to be applied to the electrostatic chuck, i.e., typically much larger than the chucking voltage used in horizontally oriented chucks. This high chucking voltage causes a considerable residual charge to reside between the wafer and the chuck after the chucking voltage is deactivated. The use of conventional dechucking techniques does not remove this large residual charge in a short period of time. As such, the throughput of the wafer processing system is detrimentally impacted.

Therefore, a need exists in the art for alternative methods for chucking a wafer and rapidly dechucking the wafer from an electrostatic chuck used in a single wafer system.

The disadvantages of the prior art are overcome by a method and apparatus for dechucking a workpiece from an electrostatic chuck using a sequence of resonant discharge events. The sequence is derived from the well known hysteretic cycle used in magnetic degaussing signals to demagnetize objects such as cathode ray tubes (CRTS). It has been discovered that using a hysteretic cycle for an electric field that is applied to the interface of a workpiece and an electrostatic chuck workpiece support surface will effectively discharge the residual charge to zero or some predefined value.

In an illustrative embodiment of the invention, the inventive method is used to discharge a monopolar electrostatic chuck having a single electrode embedded in a dielectric chuck body. To chuck a semiconductor wafer or other workpiece, a wafer is positioned upon the chuck and in contact with a conductive contact. The contact applies a first voltage to the wafer. A second voltage, having a magnitude different from the first voltage, is applied to the electrode within the chuck. The differential voltage from the wafer to the electrode causes charges to accumulate on the wafer and the electrode such that the wafer is retained upon chuck. If the chuck body is fabricated of a semiconductive material such as aluminum nitride, the charges on the electrode migrate to the surface of the chuck body beneath the wafer. As such, the surface charges on the chuck surface and the charges on the backside of the wafer retain the wafer on the chuck. This charge migration effect is known as the Johnsen-Rahbek effect. The Johnsen-Rahbek effect in a monopolar chuck provides a very effective and strong electrostatic force that retains the wafer. However, charge removal is also very difficult for such a chuck.

To rapidly dechuck the wafer from the illustrative monopolar chuck, the invention repeatedly exposes the wafer-chuck system to a sequence of resonant discharge events in rapid succession such that residual charge is removed, i.e., a hysteretic electric field is established at the interface between the wafer support surface of the chuck and the wafer. Each resonant discharge event comprises discharging the chuck using a passive resonant circuit resulting in a short-lived, rapidly decaying, degaussing waveform at the wafer-chuck interface. The form of this electric field at this interface is very important to achieving rapid dechucking of less than 200 mS.

The end result of the sequence of resonant discharge events is that the chuck, even a monopolar chuck can be discharged very rapidly, i.e., in less than 200 mS. Consequently, a single wafer/single chamber semiconductor processing system, such as a single wafer ion implant system, can process wafers with a very high throughput.

The teachings of the present invention can be readily understood by considering the following detailed description in conjunction with the accompanying drawings, in which:
FIG. 1 is a schematic cross sectional view of a semiconductor wafer process apparatus (an ion implant system) having an electrostatic chuck (ESC) for retaining a semiconductor wafer during processing therein;
FIG. 2a depicts a map of residual charge vs. applied field for an ESC;
FIG. 2b is an illustrative plot of the hysteretic loop showing the residual charge vs. applied discharge voltage during a discharge cycle of an ESC;
FIG. 3 illustrates an example of a degaussing signal waveform;
FIG. 4A depicts a schematic diagram of a passive dechucking circuit; and
FIG. 4B illustrates a model of an electrostatic chuck system with a passive dechucking circuit.

To facilitate understanding, identical reference numerals have been used, where possible, to designate identical elements that are common to the figures.

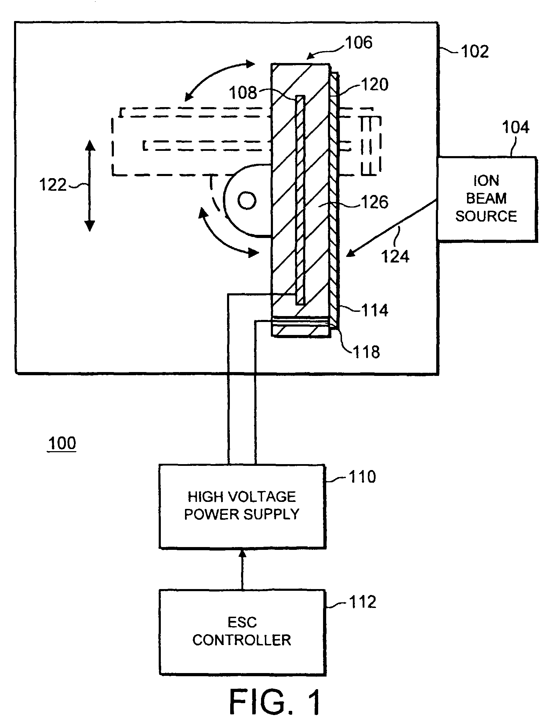

Fig. 1 is a schematic illustration of a cross-sectional view of a semiconductor wafer processing system 100, for example, an ion implant system containing a monopolar electrostatic chuck (ESC) for retaining a wafer 114 within the system during wafer processing. The ion implant system 100 comprises a vacuum chamber 102, an ion beam source 104, an electrostatic chuck 106, a high voltage power supply 110 and an ESC controller 112. The ESC 106 contains an electrode 108 embedded in a dielectric chuck body 116. The dielectric chuck body 116 is fabricated from a cylindrical puck of ceramic material such as aluminum nitride. Other dielectric materials can also be used, but aluminum nitride as well as boron-nitride, alumina doped with a titanium oxide or a chromium oxide promote the Johnsen-Rahbek effect (as described more fully below).

The electrode 108 is a plate or layer of a conductive material such as molybdenum. The electrode 108 is connected to one terminal of the high voltage power supply 110. The other terminal of the supply 110 is connected through the chuck body to a surface electrode or pin 118 extending from the wafer support surface 120. The pin 118 is designed to contact the backside of the wafer such that the chucking voltage, e.g., 500 VDC, is applied by the supply 110 through the electrode 108 to the wafer 114.

Once a chucking voltage is applied, charges migrate from the electrode to the surface of the chuck body and opposite charges are induced on the backside of the wafer such that the wafer is chucked by the Johnsen-Rahbek effect. The Johnsen-Rahbek effect is discussed in detail in US patent 5,117,121 issued May 26, 1992. The chucking force produced by the Johnsen-Rahbek (J-R) effect is very strong and permits the chuck to be positioned vertically and mechanically moved from a horizontal position (shown in phantom) to a vertical position without the wafer moving across the surface of the chuck. While in the vertical position, the chuck is physically moved in the vertical plane (as indicated by arrow 122) and the ion beam 124 is scanned horizontally such that all locations on the wafer can be exposed to the ion beam 124.

Although a J-R monopolar chuck is described as one illustrative type of electrostatic chuck that can be used with the invention, any electrostatic chuck that requires rapid discharge of a residual charge will find the present invention useful. Such chucks include bipolar chucks, dielectric chucks, multi-electrode chucks, non-Johnsen-Rahbek chucks (i.e., Coulombic chucks), and the like.

The present invention is a method of rapid dechucking of the semiconductor wafer 114 by using a passive, resonant dechuck circuit to generate a sequence of resonant discharge events in rapid succession. As a point of reference, rapid dechucking time for a ceramic ESC used in an ion implant system is on the order of less than 200msec.

The problem of "memory effect" due to residual charges occurs due to a fundamental hysteretic charging behavior of the wafer-ESC interface (along surface 120 of the chuck 106) and the region 126 between the electrode 108 and the ESC surface 120. This "memory effect" has multiple sources. For sufficiently low fields, the material is electrostatically "elastic" and retains no residual charge once the applied field is removed. However, for sufficiently large fields, a "plastic" behavior is seen and some residual charge remains even when the applied field no longer exists, i.e., after the chucking voltage is removed. While this hysteretic behavior has long been used to produce magnetic memory devices, overcoming this memory effect is also one of the long-standing challenges in developing methods for rapid dechucking.

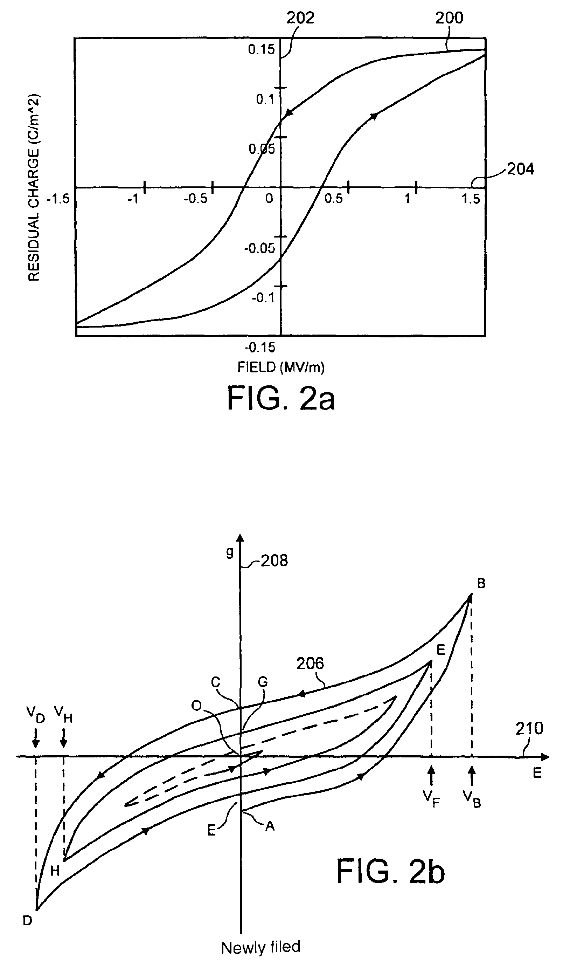

This hysteretic behavior can be illustrated by a field-charge hysteresis curve 200, which is shown in Fig. 2a, where the residual charge 202 on an ESC is plotted as a function of the applied electric field 204. The charge on the ESC follows the path AB when an increasing voltage of positive polarity is applied to the electrode-wafer. Upon decreasing the voltage, the ESC charge follows the path BC, instead of BA, because of hysteresis. Applying a similar voltage cycle at a reversed polarity brings the ESC charge along the paths CD and DA, thus completing a full hysteretic cycle. Note however, that the shape of this hysteresis curve is also time dependent, because the residual charge on the ESC will, after the applied voltage is removed from the electrode, dissipate over time due to natural charge leakage.

This charge leakage, or relaxation term is given by q=CVe^{-t/^{τ}cr}, which shows that as time approaches infinity, the surface charge becomes zero. This time-dependency of the hysteresis curve can therefore be represented in a three-dimensional plot, with the time axis being orthogonal to the page and field axes 202 and 204 shown in Fig. 2a. One can think of the true hysteresis curve as having the shape of a tube, or a sock, of decreasing cross section at larger time slices. Equivalently, the shape of the hysteresis curve is frequency dependent.

The technique of degaussing, which involves applying an external field to drive a magnet through its magnetization curve similar to that shown in Fig. 2a, has been used successfully for demagnetizing a magnet. A similar technique can also be used to return any "electret" to a zero charge state from any initial charge state. An electret is the electrostatic analogue of the magnet. Drawing from this analogy, a ferrous material can be made into a permanent magnet by subjecting the material to a magnetic field. Once removed from this field, the material retains a magnetic moment. Similarly, a dielectric material can be subject to an electrostatic field and made to retain charge once removed from this field. Just as in the magnetic case, the electret effect can be exacerbated by application of a strong electric field, suitable choice of a susceptible material and by increasing molecular mobility, usually by subjecting the material to elevated temperature or increasing exposure time. Thus, a hot process with an ESC provides fertile ground for the formation of an electret.

In degaussing an electret, a decaying, periodic signal is used to cyclically and gradually reduce the field seen by the electret (the wafer-ESC interface). The technique works because of the time and field dependence of the hysteresis. However, its effectiveness is determined by the amplitude decrement and frequency.

Indeed, this hysteretic behavior can advantageously be applied to the dechucking operation of an ESC, by subjecting the ESC to an alternating field whose magnitude, or peak amplitude, decreases over time. However, because of the large internal resistance of the J-R chuck, the applied signal may decay rapidly without effectively eliminating the residual charge. If the ESC is driven through a discharge voltage period having a peak amplitude (i.e., values of the field at B and D) which decreases with time, one can see the ESC hysteretic loop will become increasingly smaller upon successive cycles. In a dechucking operation, the complete discharge cycle ends when the applied peak voltage approaches zero, and the ESC is left at a zero residual charge state (or some predefined level of charge). The hysteretic response 206 for the ESC during such a dechucking operation is illustrated in Fig. 2b, where the ESC charge follows the path ABCD-EFGH, and so on, until it reaches the zero charge state at the end of the discharge voltage cycle. In FIG. 26, the vertical axis 208 represents residual charge (9) and the horizontal axis 210 represents the electric field (E).

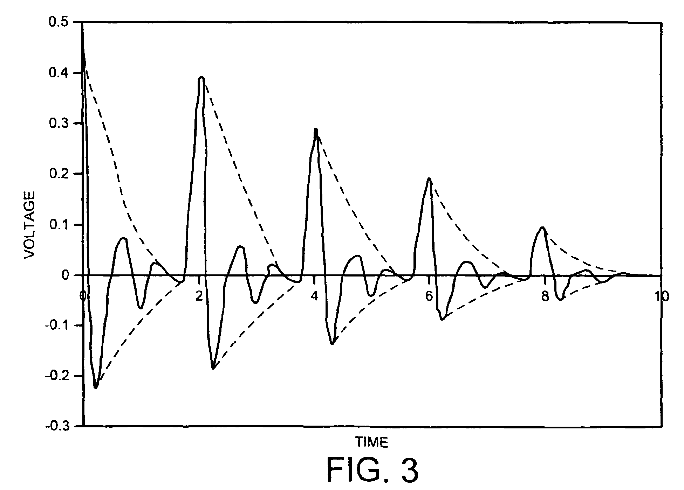

Many different signal waveforms can be used as the discharge voltage for discharging an ESC, as long as they are applied in a periodic fashion that achieves the discharge path of Fig 2b. In one embodiment of the invention, the discharge waveform is a sequential application of rapidly decaying signals whose peak magnitude decreases with time. Fig. 3 illustrates the possible signal profile. Specifically, the waveform is a plurality of decaying AC waveforms, where each AC waveform has an initial peak amplitude that is less than the peak amplitude of the previous AC waveform in the series of waveforms.

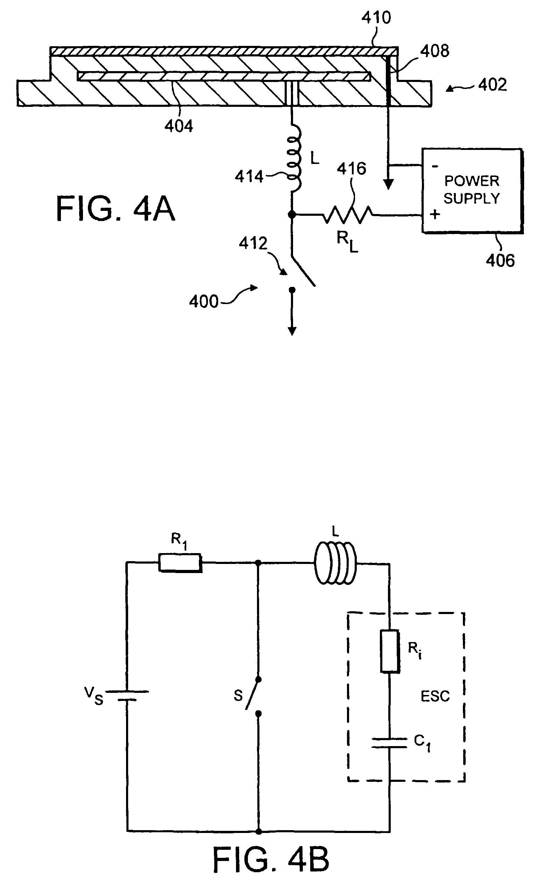

FIG. 4A depicts a schematic of a passive dechucking circuit 400 connected to an electrostatic chuck 402. In the illustrative monopolar chuck, the electrode 404 is connected to one polarity of the DC power supply 406 through a load resistance 416. The other polarity (ground) is connected to a contact 408 that conductively contacts the wafer 410 in one or more locations on the backside of the wafer 410. The dechucking circuit 400 comprises a switch 412 and the inductor 414. A simplified model of the electrostatic chuck system with the passive dechucking circuit is illustrated in FIG. 4B.

Referring to FIG. 4A, in this embodiment of the invention, an exponentially decaying sinusoidal oscillation in electrode potential is passively generated when the switch 412 is closed, in that, the wafer-chuck interface forms a capacitor (shown Cᵢ in FIG. 4B) that discharges its stored energy through the inductor 414 producing a resonant circuit. The frequency of oscillation is between 100 and 200 kHz. The internal resistance (shown Rᵢ in FIG. 4B) inside the electrostatic chuck 402 dissipates energy from the resonant circuit during each cycle of the oscillation. The switch 412 is opened and closed again resulting in another decaying sinusoidal potential trace, but starting at a lower peak voltage. This process of opening and closing the switch 412 is repeated several times, each subsequent trace resulting in a lower initial voltage, until the residual charge is sufficiently low to facilitate removal of the wafer 410.

Of course, if a non-zero attractive force is desired at the end of the dechucking period, then the "dechucked" state has a corresponding non-zero charge. In many applications for electrostatic chucks, all of the charge may not require removal to enable the wafer to be removed from the chuck, i.e., a nominal residual charge may be overcome by a wafer transfer mechanism (lift pins, wafer gripper robot, and the like). As such, the residual charge is reduced to a non-zero, nominal level that permits wafer removal. By not discharging the residual charge to zero the overall dechucking time is shortened. Additionally, a residual non-zero force may be useful in applications where the workpiece may slide off the chuck surface unless some force retains the workpiece until a workpiece manipulator can retrieve the workpiece from the chuck. Or, a residual charge may be desirable to repel charged particles from the chuck surface after the wafer is removed from the chuck.

Although the illustrative embodiment utilizes a DC chucking source, the present invention is useful for dechucking electrostatic chucks with AC chucking sources as well. With AC chucking sources, however, the passive dechucking circuit is only switched into the electrostatic chuck system for dechucking the wafer from the chuck. Otherwise, the inductor would act as a large resistance to the AC source affecting the chucking process.

The present invention generally provides a discharge cycle having a signal waveform such that this zero charge state (or nominal charge state) can be achieved for the electrostatic chuck system within a predetermined, or desired, dechucking time t_{d}. Of course, the desired dechucking time may vary depending on the specific process application. In general, a shorter dechucking time is desirable because it translates directly to an increased process throughput.

Although various embodiments which incorporate the teachings of the present invention have been shown and described in detail herein, those skilled in the art can readily devise many other varied embodiments that still incorporate these teachings.

## Claims

1. A method of chucking and dechucking a workpiece from an electrostatic chuck comprising the steps of:
applying a chucking voltage to an electrode within said electrostatic chuck to electrostatically retain said workpiece upon a workpiece support surface of the electrostatic chuck;
applying a dechucking voltage comprising a sequence of resonant discharge events to said electrode to produce an electric field between the workpiece and the workpiece support surface of the electrostatic chuck, whereby the electric field discharges a charge that has accumulated between the workpiece and the workpiece support surface of the electrostatic chuck.

2. A method as claimed in claim 1, wherein said electrostatic chuck is a monopolar electrostatic chuck having said chucking and dechucking voltages applied across the workpiece and an electrode within the electrostatic chuck.

3. A method as claimed in claim 1 or claim 2, wherein the chucking voltage is a DC voltage.

4. A method as claimed in any of claims 1 to 3, wherein each of said resonant discharge events has a waveform with a peak amplitude which diminishes with time.

5. A method as claimed in any of claims 1 to 4, wherein said dechucking voltage is passively produced using energy stored between the workpiece and electrostatic chuck.

6. A method as claimed in claim 5, wherein the stored energy is discharged through a loading circuit, where a resistance of a resistive element in said loading circuit is defined to produce a specific discharge profile.

7. A method as claimed in claim 5 or claim 6, wherein the resistive element is an internal resistance due to a finite volume resistivity of the material comprising the electrostatic chuck.

8. In an ion implant system having a electrostatic chuck, a method of chucking and dechucking a semiconductor wafer comprising the steps of:
applying a chucking voltage to an electrode within said electrostatic chuck to electrostatically retain said semiconductor wafer upon a wafer support surface of the electrostatic chuck;
processing said semiconductor wafer;
applying a dechucking voltage comprising a sequence of resonant discharge events to said electrode to produce an electric field between the semiconductor wafer and the wafer support surface of the electrostatic chuck, whereby the electric field discharges a charge that has accumulated between the semiconductor wafer and the wafer support surface of the electrostatic chuck.

9. A method as claimed in claim 8, wherein the chucking voltage is a DC voltage.

10. A method as claimed in claim 8 or claim 9, wherein each of said resonant discharge events has a waveform with a peak amplitude which diminishes with time.

11. A method as claimed in any of claims 8 to 10, wherein said dechucking voltage is passively produced using energy stored between the workpiece and electrostatic chuck.

12. A method as claimed in claim 11, wherein the stored energy is discharged through a loading circuit, where a resistance of a resistive element in said loading circuit is defined to produce a specific discharge profile.

13. A method as claimed in claim 11 or claim 12, wherein the resistive element is an internal resistance due to a finite volume resistivity of the material comprising the electrostatic chuck.

14. Apparatus for dechucking a workpiece from an electrostatic chuck having at least one electrode comprising:
an inductor selectively coupled between said at least one electrode and ground;
and
a resistive element, selectively coupled between said at least one electrode and ground, having a resistance value that produces a specific discharge voltage profile for energy stored between said workpiece and a workpiece support surface of said electrostatic chuck.

15. A method as claimed in claim 14, wherein the resistive element is an internal resistance due to a finite volume resistivity of the material comprising the electrostatic chuck.

16. An ion implant system comprising:
an ion beam generator; coupled to a vacuum chamber;
an electrostatic chuck positioned within said vacuum chamber, where said electrostatic chuck has at least one electrode; an inductor selectively coupled between said at least one electrode and ground; and
a resistive element, selectively coupled between said at least one electrode and ground, having a resistance value that produces a specific discharge voltage profile for energy stored between said workpiece and a workpiece support surface of said electrostatic chuck.

17. A method as claimed in claim 16, wherein the resistive element is an internal resistance due to a finite volume resistivity of the material comprising the electrostatic chuck.

18. An electrostatic chuck having means for chucking and dechucking a workpiece, comprising, means for applying a chucking voltage to an electrode within said electrostatic chuck to electrostatically retain said workpiece upon a workpiece support surface of the electrostatic chuck and means for applying a dechucking voltage comprising a sequence of resonant discharge events to said electrode to produce an electric field between the workpiece and the workpiece support surface of the electrostatic chuck, whereby the electric field discharges a charge that has accumulated between the workpiece and the workpiece support surface of the electrostatic chuck.

19. An apparatus as claimed in claim 18 wherein said electrostatic chuck is a monopolar electrostatic chuck and said means for applying chucking and dechucking voltages apply said voltages across the workpiece and an electrode within the electrostatic chuck.

20. An apparatus as claimed in claim 18 or claim 19, wherein the means for applying chucking voltages applies a DC voltage.

21. An apparatus as claimed in any of claims 18 to 20, wherein said means for applying dechucking voltages is arranged to cause each of said resonant discharge events to have a waveform with a peak amplitude which diminishes with time.

22. An apparatus as claimed in any of claims 18 to 21, wherein said dechucking voltage is passively produced using energy stored between the workpiece and electrostatic chuck.

23. An apparatus as claimed in claim 22, wherein the stored energy is discharged through a loading circuit, where a resistance of a resistive element in said loading circuit is defined to produce a specific discharge profile.

24. An apparatus as claimed in claim 22 or claim 23, wherein the resistive element is an internal resistance due to a finite volume resistivity of the material comprising the electrostatic chuck.
